Europäisches Patentamt

European Patent Office

Office européen des brevets

(19)

(11) Numéro de publication: **0 075 376**
**B1**

(12) # FASCICULE DE BREVET EUROPEEN

(45) Date de publication du fascicule du brevet:
24.07.85

(51) Int. Cl.⁴: **H 03 J 5/02**

(21) Numéro de dépôt: **82201176.3**

(22) Date de dépôt: **22.09.82**

(54) **Procédé de gestion des commandes de fréquence d'un poste émetteur-récepteur et de la programmation du compteur programmable de son synthétiseur numérique de fréquence.**

(30) Priorité: **23.09.81 FR 8117916**

(43) Date de publication de la demande:
**30.03.83 Bulletin 83/13**

(45) Mention de la délivrance du brevet:
**24.07.85 Bulletin 85/30**

(84) Etats contractants désignés:
**DE FR GB IT SE**

(56) Documents cités:
**EP - A - 0 038 580**
**FR - A - 2 170 908**
**US - A - 4 057 760**
**US - A - 4 247 951**

**FUNKSCHAU., vol. 51, no. 18, août 1979, pages 1041-1043, Munich (DE); U. SCHILLHOF: "Das Rundfunk-Abstimmsystem RTS"**

(73) Titulaire: **TELECOMMUNICATIONS RADIOELECTRIQUES ET TELEPHONIQUES T.R.T., 88, rue Brillat Savarin, F-75013 Paris (FR)**
(84) Etats contractants désignés: **FR**

(73) Titulaire: **N.V. Philips' Gloeilampenfabrieken, Groenewoudseweg 1, NL-5621 BA Eindhoven (NL)**
(84) Etats contractants désignés: **DE GB IT SE**

(72) Inventeur: **Defeuilley, Jean-Pierre, SOCIETE CIVILE S.P.I.D. 209 rue de l'Université, F-75007 Paris (FR)**
Inventeur: **Nguyen-van-Nguyen, Jean, SOCIETE CIVILE S.P.I.D. 209 rue de l'Université, F-75007 Paris (FR)**

(74) Mandataire: **Chaffraix, Jean et al, Société Civile S.P.I.D. 209, rue de l'Université, F-75007 Paris (FR)**

## Description

L'invention concerne un procédé de gestion des commandes de fréquence d'un poste émetteur-récepteur avec synthétiseur de fréquence, la boucle de verrouillage de phase dudit synthétiseur comportant entre autres un dispositif oscillateur à plusieurs oscillateurs commandables et un dispositif diviseur de fréquence variable qui reçoit sous la forme d'un code numérique l'information de la fréquence de commande dudit synthétiseur à travers un circuit de transcodage constitué par des mémoires, ledit circuit de transcodage recevant sous la forme d'un autre code numérique l'information de la fréquence de commande dudit poste émetteur-récepteur affichée par l'opérateur au moyen d'un dispositif d'affichage de fréquence qui comporte différentes décades; l'affichage sur chacune d'elles pouvant être varié par pas, ledit dispositif diviseur de fréquence variable comportant la chaîne de division proprement dite formée principalement d'un premier compteur programmable associé à une première et à une seconde mémoire dudit circuit de transcodage et d'un diviseur par 10 ou par 11 commandé soit par un second, soit par un troisième compteur programmable, lesdits second et troisième compteurs programmables étant associés respectivement à une troisième et à une quatrième mémoire du circuit de transcodage.

Dans un poste émetteur-récepteur, les fréquences de réception et d'émission (qui peuvent être différentes) sont déterminées par le synthétiseur de fréquence dans le cas d'un appareil multicanaux et par les dispositifs d'accord automatique principalement ceux du récepteur.

La gestion des informations de commande du synthétiseur et des dispositifs d'accord nécessite le traitement des informations issues des organes de commande à disposition de l'opérateur de manière à ce que leur action aboutisse à la mise en oeuvre des seules fonctions requises.

Le brevet des Etats-Unis d'Amérique US-A-4 057 760 décrit un procédé de gestion des commandes de fréquences d'un poste récepteur. Dans ce procédé, les signaux numériques de commande du diviseur programmable du synthétiseur et de la logique de commande sont issus d'un dispositif de programmation mécanique réalisé sous la forme d'un peigne métallique enfiché dans un connecteur. La fréquence fournie par le synthétiseur est fixée à la valeur programmée sur le peigne. Aucune opération de «calcul» sur le code de fréquence à proprement parler n'est possible.

Par ailleurs, le dispositif de programmation mécanique à peigne utilisé nécessite une intervention manuelle de reprogrammation en cas de changement de fréquence.

Dans le cas d'une réception en mode supradyne ou en mode infradyne, la fréquence à synthétiser est différente de la fréquence de commande du poste émetteur-récepteur, le décalage en fréquence étant égal à la valeur de la première fréquence intermédiaire.

Le but de l'invention est de fournir un procédé de transcodage des codes de ladite fréquence de commande du poste en codes requis pour le fonctionnement en mode émission ou en mode réception dudit dispositif diviseur de fréquence, les opérations arithmétiques sur ces codes étant effectuées de manière à respecter le plan de fréquence du poste émetteur-récepteur.

A cet effet et conformément à l'invention, ledit circuit de transcodage constitué par lesdites mémoires reçoit les informations du mode de fonctionnement émission ou réception et les informations codées des valeurs de fréquence de commande dudit poste de manière à déterminer par le calcul selon les valeurs de la fréquence intermédiaire, de la fréquence de référence et du pas d'incrémentation en fréquence, les valeurs de fréquence de commande du synthétiseur, l'inversion du mode de fonctionnement supradyne/infradyne, la sélection des filtres correspondant aux sous-gammes du récepteur, la sélection desdits oscillateurs commandables et l'élaboration des fréquences interdites, l'algorithme régissant ledit calcul étant constitué par la programmation desdites mémoires.

La description suivante en regard des dessins annexés, le tout donné à titre d'exemple fera bien comprendre comment l'invention peut être réalisée.

La figure 1 représente le schéma de principe du synthétiseur de fréquence utilisant des mémoires pour la conversion entre le code d'affichage et la commande des compteurs programmables.

La figure 2 donne la structure du dispositif diviseur de fréquence variable.

La figure 3 donne un exemple de transcodage pour un fonctionnement en émission.

Les figures 4 et 5 donnent des exemples de transcodage pour un fonctionnement en réception supradyne.

Les figures 6, 7 et 8 donnent des exemples de transcodage pour un fonctionnement en réception infradyne.

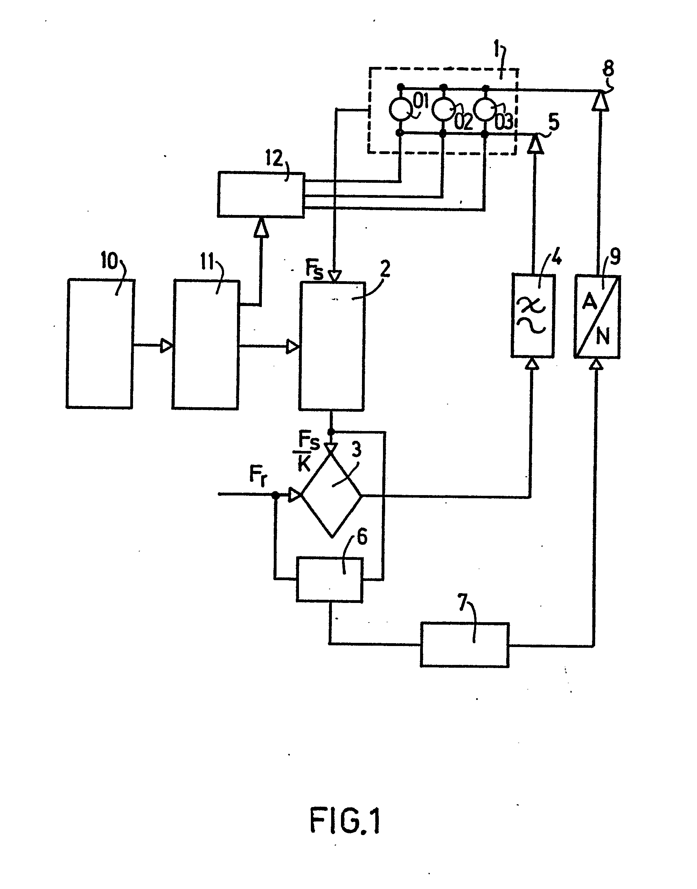

La figure 1 représente le schéma de principe du synthétiseur de fréquence dit à synthèse directe, à commande numérique dont la boucle de verrouillage de phase comprend le dispositif oscillateur 1 à plusieurs oscillateurs commandables (pour décrire le fonctionnement on en a supposé trois O1, O2 et O3) l'un d'eux fournissant après sélection la fréquence de commande du synthétiseur $F_S$, le dispositif diviseur de fréquence variable 2 divisant la fréquence $F_S$ par K, le discriminateur de phase 3 qui reçoit la fréquence de référence $F_r$ et la fréquence divisée $\dfrac{F_S}{K}$, le filtre de boucle passe-bas 4 qui fournit à l'entrée 5 de l'oscillateur sélectionné une tension de commande de fréquence. La présence du filtre 4 limite la plage de synchronisation de l'oscillateur à une faible écart de fréquence $\Delta F$ auquel la différence $\left| F_r - \dfrac{F_S}{K} \right|$ doit être inférieure pour que se produise l'accrochage de la boucle. Cet accrochage s'effectue plus rapidement grâce à un circuit de recherche de prépositionnement de la fréquence libre de l'oscillateur à une valeur voisine de la fréquence de commande $F_S$ désirée. Ce prépositionnement est obtenu à l'aide d'un discriminateur de fréquence à comptage 6 qui fournit des impulsions lorsque l'écart entre $F_r$ et $F_S/K$ est important. Ces impulsions sont appliquées à un compteur 7 dont le contenu est converti en tension continue appliquée sur l'entrée 8 de l'oscillateur sélectionné au moyen du convertisseur numérique-analogique 9. Cette tension s'annule brusquement chaque fois que le compteur 7 est remis automatiquement sur sa position initiale après avoir atteint sa position finale. Lorsque la différence $\left| F_r - \dfrac{F_s}{K} \right|$ devient inférieure à l'écart de fréquence $\Delta F$, le discriminateur de fréquence 6 ne fournit plus d'impulsions, le compteur 7 ne progresse plus et la tension en 8 demeure constante ce qui a pour effet de déclencher l'accrochage de la boucle de verrouillage de phase.

Les informations codées de la fréquence de commande $F_A$ du poste émetteur-récepteur fournies par l'opérateur au moyen du dispositif d'affichage de fréquence 10 sont appliquées au circuit de transcodage 11 constitué par des mémoires et qui fournit d'autres informations codées servant à la commande du dispositif diviseur de fréquence variable 2.

Les informations codées contenues dans les mémoires du circuit de transcodage 11 sont également utilisées pour programmer les informations de commande des différentes fonctions du poste émetteur-récepteur entre autres la fonction sélection des oscillateurs, le circuit de décodage 12 transformant le code programmé en un code 1 parmi 3 directement utilisable pour commander lesdits oscillateurs.

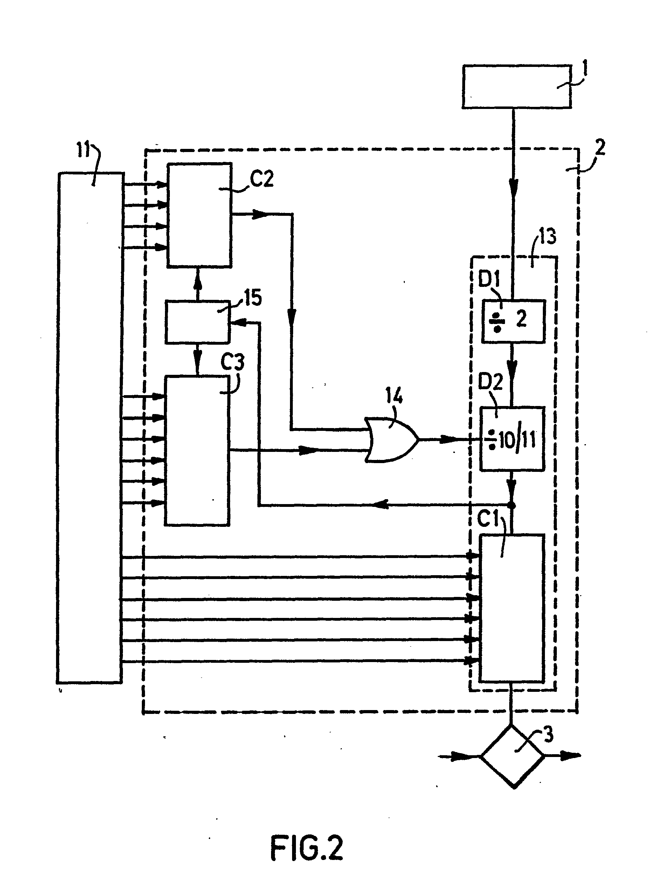

Pour comprendre le fonctionnement de ces mémoires, il est nécessaire de décrire à l'aide d'un exemple le fonctionnement du dispositif diviseur de fréquence variable 2 dont le schéma est représenté sur la figure 2 et dont la fonction est de fournir au comparateur de phase 3 une fréquence constante égale à la fréquence de référence quel que soit l'affichage.

On considère un poste émetteur-récepteur devant couvrir la gamme 225 à 399,975 MHz par pas de 25 kHz en émission comme en réception avec une fréquence de référence fixée à 0,5 MHz et on suppose par exemple que la fréquence à synthétiser est de 276,450 MHz.

La partie principale du dispositif diviseur de fréquence variable 2 est la chaîne de division 13 comprenant le diviseur par deux D1 recevant l'information de fréquence de sortie issue du dispositif oscillateur 1 suivi du diviseur par 10 ou par 11 D2 et du compteur programmable C1 relié au discriminateur de phase 3. Le diviseur par deux D1, permet dans la gamme de fréquences ci-dessus une réalisation plus simple du diviseur par 10 ou par 11. Le compteur C1 devant diviser par le nombre formé par le chiffre des centaines et le chiffre des dizaines de MHz (27 dans l'exemple donné) est programmé au complément de sa capacité maximum 63, c'est-à-dire 63 — 27 = 36.

La commande «diviser par 10 ou par 11» de D2 est issue soit du compteur programmable C2, soit du compteur programmable C3 à travers le circuit OU 14.

Un dispositif annexe de synchronisation 15 assure l'avance synchrone des compteurs C2 et C3 de manière à ce que l'information de commande de D2 change d'état au moment voulu compte tenu du nombre d'impulsions apparues à sa sortie.

Le compteur C2 devant compter le nombre fourni par le chiffre des unités de MHz (6 dans l'exemple considéré) est programmé au complément de sa capacité maximum 14 soit 14 — 6 = 8.

Le compteur C3 devant compter le nombre de pas de 25 kHz contenus dans le nombre formé par les chiffres des centaines, des dizaines et des unités de kHz (18 dans l'exemple considéré) est programmable de 0 à 40 (40 étant le nombre de pas de 25 kHz contenus dans 1 MHz).

Après division par deux en sortie de D1, on doit compter dans un intervalle de temps de 2 $\mu s$ 276,450 impulsions en moyenne à l'entrée du diviseur par 10 ou par 11 D2. Cela peut être réalisé en deux phases par la méthode du «Pas après virgule».

Au départ de la première phase, D2 reçoit de C2 la commande «diviser par 11» et sa programmation est telle qu'il compte une unité de plus par rapport à la programmation du chiffre unités de MHz sur C2 soit 6 + 1 = 7. Pendant chaque cycle de 2 $\mu s$, D2 divise ainsi 7 fois par 11 et 20 fois par 10. A chaque division par 11 de D2, l'impulsion qui apparaît à sa sortie fait avancer le compteur C2 d'une unité par l'intermédiaire du dispositif de synchronisation 15. Lorsque D2 a compté 6 impulsions de sortie, C2 a atteint l'état 14 c'est-à-dire sa capacité maximum. D2 divise alors une autre fois par 11 avant de recevoir de C2 la commande «diviser par 10». Ce cycle se renouvelle 18 fois c'est-à-dire jusqu'à ce que le compteur C3 qui par l'intermédiaire du dispositif de synchronisation 15 avance d'une unité après chaque cycle de 2 $\mu s$, ait atteint l'état 18.

La deuxième phase commence à partir de l'état 19 de C3. D2 reçoit de C3 l'ordre de compter le nombre d'impulsions correspondant à la programmation de C2 c'est-à-dire 6. Ainsi, pendant chaque cycle de 2 $\mu s$, D2 divise 6 fois par 11 jusqu'à ce que C2 ait atteint l'état 14 et 21 fois par 10. Ce cycle se renouvelle 40 — 18 = 22 fois.

Sur un total de 40 cycles de 2 $\mu s$ on a compté en moyenne

$$\frac{(7 \times 11 + 20 \times 10)18 + (6 \times 11 + 21 \times 10)22}{40} =$$

$$\frac{277 \times 18 + 276 \times 22}{40} = 276,450 \text{ impulsions.}$$

Après division par 27, le compteur C1 fournit en sortie 40 impulsions en 80 $\mu s$, c'est-à-dire la fréquence de référence de 0,5 MHz.

D'une façon plus générale, pour réaliser le «Pas après virgule», on va dire que pendant p cycles de comptage avec p = a + b, on divise a cycles par N (nombre correspondant aux unités, dizaines et centaines de MHz) et b cycles par N + 1 et on fait la moyenne sur p:

$$\frac{aN + b(N + 1)}{p} = \frac{N(a + b)}{p} = N + \frac{b}{p}$$

On a un nouveau rapport de division:

$$N_o = N + \frac{b}{p}$$

Si p est égal à 40 cycles, $\dfrac{b}{40}$ représente la partie après virgule.

Dans l'exemple ci-dessus on a synthétisé

276,450 MHz·N = 276, N + 1 = 277

$$\frac{b}{40} = 0,450 \text{ et } b = 18 \text{ (18 fois N + 1)}$$

et a = p — b = 40 — 18 = 22.

Cette méthode bien connue permet d'économiser de la capacité de comptage du diviseur programmable en utilisant l'observation à long terme (valeur moyenne) de la fréquence synthétisée, mais le rythme de comptage n'étant plus constant il s'ensuit la création de raies parasites qu'il faut ensuite éliminer par filtrage dans la boucle de phase.

Les mémoires du circuit de transcodage 11 transmettent aux compteurs C1, C2 et C3 les impulsions codées correspondant à la valeur de la fréquence à synthétiser.

Selon l'invention, la programmation desdites mémoires détermine le fonctionnement de l'appareil en émission et en réception d'après le plan de fréquence établi par l'algorithme de calcul. L'utilisation des mémoires M1 à M4 du circuit de transcodage 11 permet d'effectuer simplement la commande du compteur programmable 2 lorsque le synthétiseur est utilisé dans un poste radioélectrique émetteur-récepteur où la fréquence que fournit le synthétiseur est différente selon que le poste est en émission ou en réception et si éventuellement le fonctionnement en réception est en supradyne ou en infradyne.

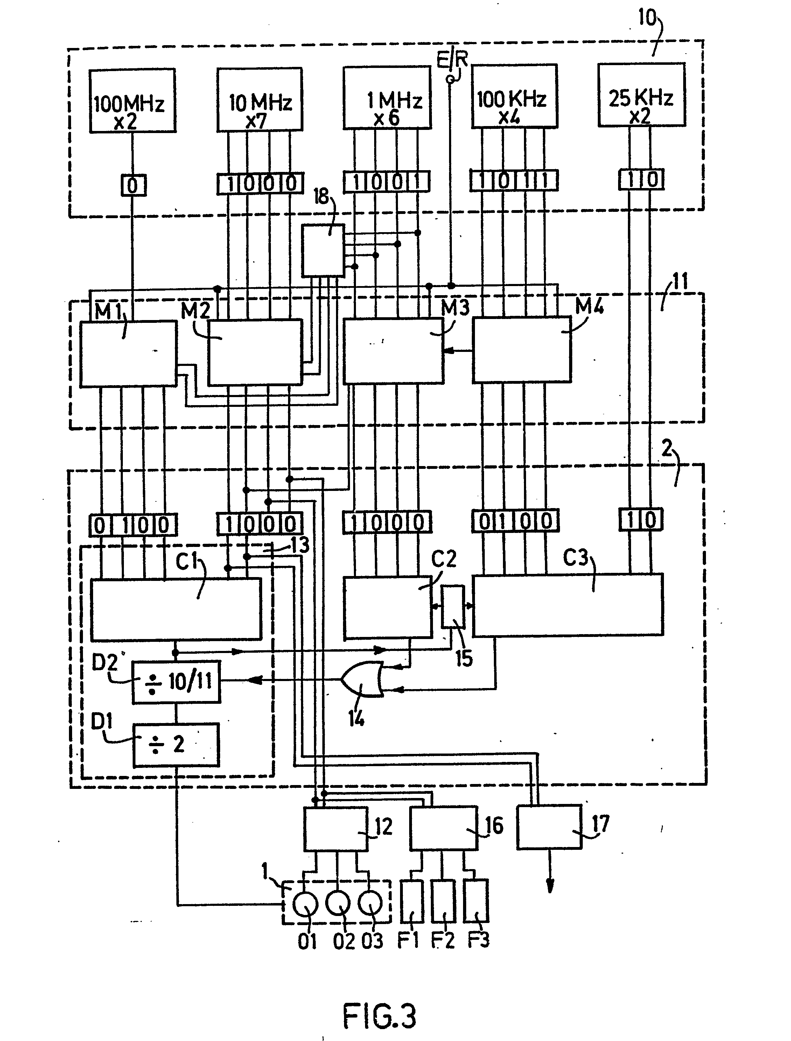

La figure 3 montre l'ensemble des transcodages dans le cas du fonctionnement en émetteur à la fréquence de 276,450 MHz ainsi que l'utilisation des mémoires pour la programmation des différentes fonctions de commande.

L'information Emission/Réception E/R est transmise simultanément à quatre circuits mémoire M1, M2, M3 et M4 constituant le circuit de transcodage 11. Le dispositif d'affichage de fréquence 10 comporte différentes décades: centaines, dizaines et unités de MHz, centaines de kHz et une décade de 25 kHz, l'affichage sur chacune de ces décades pouvant être varié par pas unitaires. Ce dispositif d'affichage fournit un code en $\overline{\text{BCD}}$ pour les pas de 10 MHz, 1 MHz, 100 kHz et un code binaire naturel pour les pas de 100 MHz et 25 kHz. Le rôle des mémoires M1 à M4 est de transcoder les codes précédents en un code binaire naturel requis pour le fonctionnement du dispositif diviseur de fréquence variable 2 décrit ci-dessus et d'effectuer dans le fonctionnement en récepteur les opérations arithmétiques sur ces codes de manière à respecter le plan de fréquence établi lors du fonctionnement en émetteur pour lequel la fréquence de commande du synthétiseur est identique à la fréquence de commande du poste affichée par l'opérateur.

Dans le cas du fonctionnement en émetteur à la fréquence de 276,450 MHz, le compteur C3 est programmé en binaire naturel directement issu de l'affichage de fréquence 25 kHz (10 pour l'exemple considéré). La mémoire M4 adressée par le code $\overline{\text{BCD}}$ de l'affichage des centaines de kHz (1011 pour l'exemple considéré) transmet au compteur C3 le code correspondant en binaire naturel (0100 pour l'exemple considéré). Ainsi la juxtaposition des codes transmis au compteur C3 correspond bien au nombre de pas de 25 kHz contenus dans l'affichage des 100 kHz et des 25 kHz (10010 pour l'exemple considéré).

La mémoire M3 adressée par le code $\overline{\text{BCD}}$ de l'affichage des unités de MHz (1001 pour l'exemple considéré) est associée au compteur C2 programmé en binaire naturel au complément à 14 du chiffre des unités de MHz (1000 pour l'exemple considéré).

Les mémoires M1 et M2 sont adressées par le code $\overline{\text{BCD}}$ de l'affichage des dizaines de MHz (1000 pour l'exemple considéré) et par l'information à un seul digit de l'affichage des centaines de MHz: 0 pour 2 centaines de MHz et pour l'exemple considéré ou 1 pour 3 centaines de MHz. Le compteur C1 qui leur est associé est programmé en binaire naturel au complément à 63 du nombre formé par le chiffre des centaines et celui des dizaines de MHz (100100 pour l'exemple considéré). Le contenu de M1 correspond à la programmation des quatre digits de poids faible et celui de M2 à la programmation des deux digits de poids fort.

Les mémoires du circuit de transcodage 11 sont utilisées pour programmer les fonctions de commande des différents organes nécessaires au fonctionnement du poste émetteur-récepteur.

La fonction sélection des filtres correspondant aux sous-gammes du récepteur est assurée par la mémoire M2. Dans la gamme de fonctionnement considérée, les sous-gammes du récepteur sont par exemple:

1re sous-gamme: 225 à 279,975 MHz à laquelle correspond le filtre F1

2me sous-gamme: 280 à 339,975 MHz à laquelle correspond le filtre F2

3me sous-gamme: 340 à 399,975 MHz à laquelle correspond le filtre F3.

Les deux digits de M2 non utilisés pour la programmation de C1 le sont pour la programmation des sous-gammes de la manière suivante:

1re sous-gamme: 0 0

2me sous-gamme: 0 1

3me sous-gamme: 1 0.

Pour l'exemple considéré, c'est le code 0 0 qui doit être programmé.

Un circuit de décodage 16 transforme ce code en un code 1 parmi 3 directement utilisable pour commander les filtres du récepteur (filtre F1 pour l'exemple considéré).

Comme indiqué précédemment, les oscillateurs du synthétiseur sont sélectionnés en fonction de la fréquence affichée. Dans l'exemple donné les sous-gammes 0 1, 0 2 et 0 3 du dispositif oscillateur 1 sont identiques aux sous-gammes du récepteur. Ainsi le circuit de décodage 12 fonctionne de manière identique au circuit 16 avec les mêmes informations d'entrée. Mais toute autre combinaison de sous-gamme est possible en fonction d'un contenu mémoire M2 adéquat (pour l'exemple considéré c'est l'oscillateur 0 1 qui est sélectionné).

Pour le poste émetteur-récepteur donné en exemple, il est possible d'afficher des fréquences à partir de 200 MHz. Or la gamme utilisable l'est à partir de 225 MHz. La programmation de C1 par le code 1 0 donnée par M2 inclut également les fréquences de 200 à 224 MHz. Pour l'affichage de ces fréquences interdites, le code 1 1 apparaît en sortie de M2 au lieu du code 1 0, la substitution de 1 à 0 sur le deuxième digit du contenu de M2 étant effectuée à travers M3. Le circuit NON ET 17 donne alors une information logique 0.

En réception, le poste peut fonctionner en supradyne ou en infradyne selon la valeur de la fréquence de commande $F_A$ affichée par l'opérateur, le décalage par rapport à cette fréquence étant égal à la valeur de la première fréquence intermédiaire $F_1$.

L'information E/R transmise au circuit de transcodage 11 a pour fonction de décaler la fréquence de sortie du synthétiseur de la valeur de ladite fréquence intermédiaire. Ceci est réalisé en changeant par cette information le rapport de division du diviseur programmable qui lui-même est établi par la programmation des compteurs C1, C2 et C3. Cette programmation est modifiée suivant une loi introduite dans les mémoires M1 à M4 par changement de leur adressage.

Dans la zone de fréquence où le récepteur fonctionne en supradyne, la fréquence du signal de commande du synthétiseur $F_{Ss}$ est donc la fréquence de commande $F_{As}$ affichée par l'opérateur à laquelle il faut ajouter la valeur de la première fréquence intermédiaire:

$$F_{Ss} = F_{As} + F_I$$

Dans la zone de fréquence où le récepteur fonctionne en infradyne, la fréquence $F_{Si}$ du signal fourni par le synthétiseur est la fréquence de commande $F_{Ai}$ affichée par l'opérateur à laquelle il faut retrancher la valeur de la première fréquence intermédiaire:

$$F_{Si} = F_{Ai} - F_I$$

Pour la gamme de fréquence couverte par le poste émetteur-récepteur indiquée ci-dessus, la réception est en mode supradyne entre 225 et 319,975 MHz et en mode infradyne entre 320 et 399,975 MHz, la première fréquence intermédiaire étant de 90,5 MHz.

Si la fréquence de commande affichée est par exemple de 300 MHz on est donc en réception supradyne et la programmation du diviseur de fréquence 2 doit correspondre à $F_{Ss} = 300 + 90,5 = 390,5$ MHz. Si la fréquence de commande affichée est modifiée de 300 à 300,5 MHz, la programmation du diviseur 2 doit correspondre à $F_{Ss} = 300,5 + 90,5 = 391$ MHz.

Cet exemple montre qu'à partir du pas 5 de la décade d'affichage des centaines de kHz, il est nécessaire de tenir compte d'une retenue et de la propager au niveau de la programmation de la commande des unités de MHz.

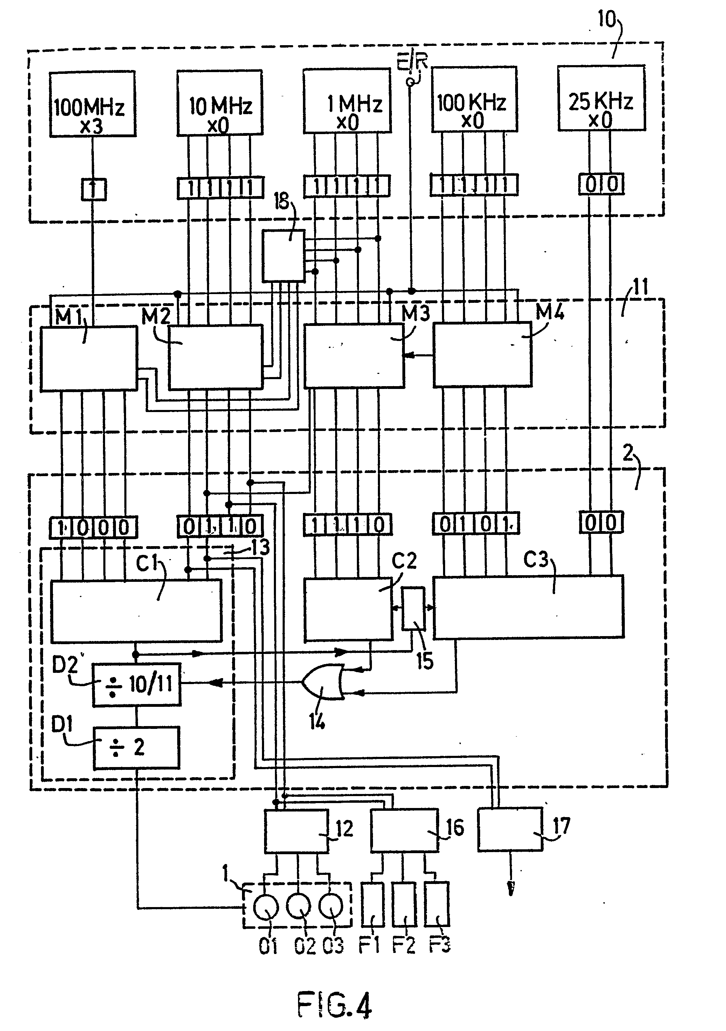

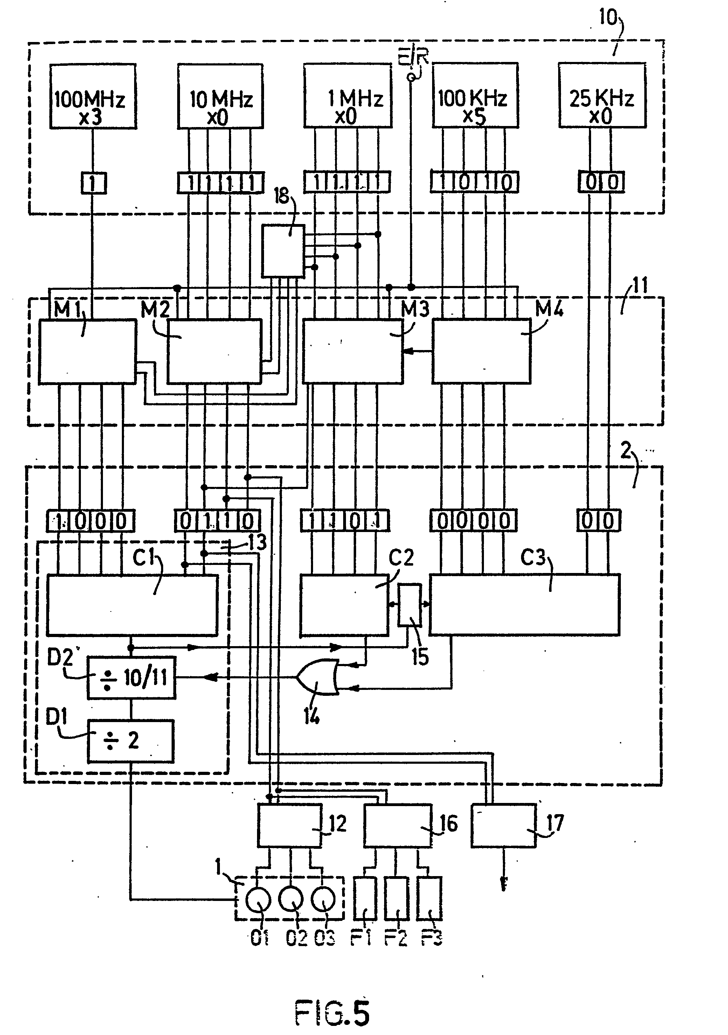

Les figures 4 et 5 montrent l'ensemble des transcodages pour les fréquences de commande affichées de 300 et 300,5 MHz respectivement.

En réception infradyne, il faut retrancher 90,5 MHz à la valeur de fréquence de commande affichée ou ce qui revient au même, retrancher 100 MHz et ajouter 9,5 MHz. Si par exemple 320 MHz est affichée on a: $F_{Si} = 320 - 90,5 = 229,5$ MHz. Si par contre

320,5 est affichée on a: $F_{Si} = 320,5 - 90,5 = 230$ MHz avec une première retenue propagée au niveau de la programmation de la décade d'affichage des unités de MHz (cas précédent) et une seconde retenue au niveau de la programmation de la décade des dizaines de MHz. Mais 230 pouvant s'écrire 220 + 10, on remarque que le nombre 10 est inférieur au nombre 14 valeur de la capacité maximum du compteur C2. Il n'est donc pas nécessaire dans ce cas de propager la retenue. Le compteur C2 doit être programmé à 4 MHz.

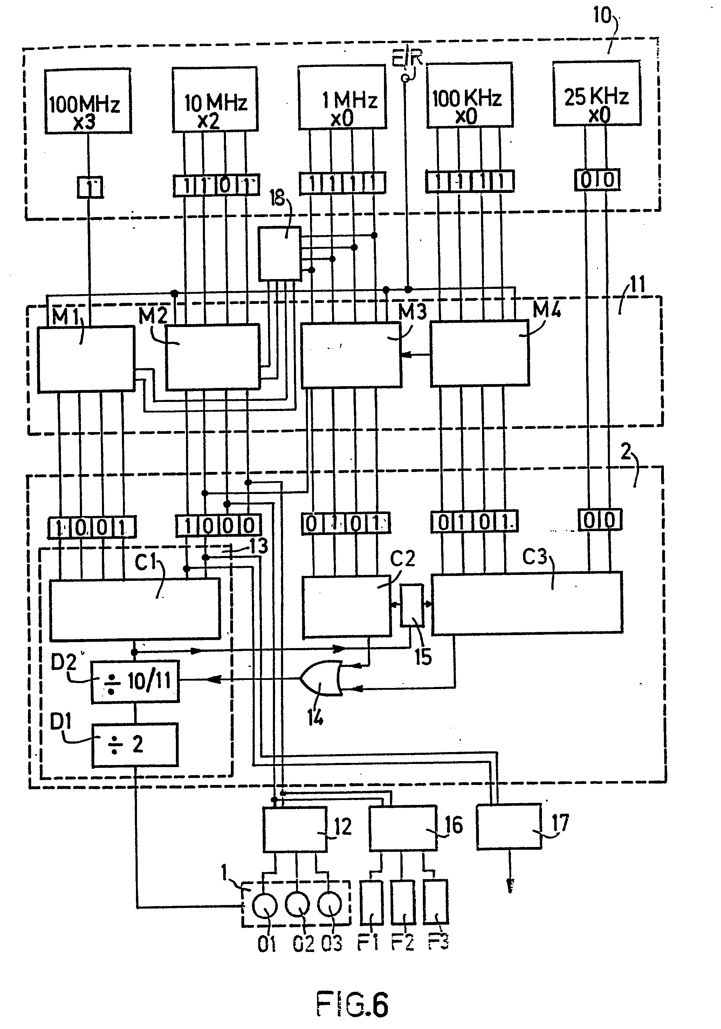

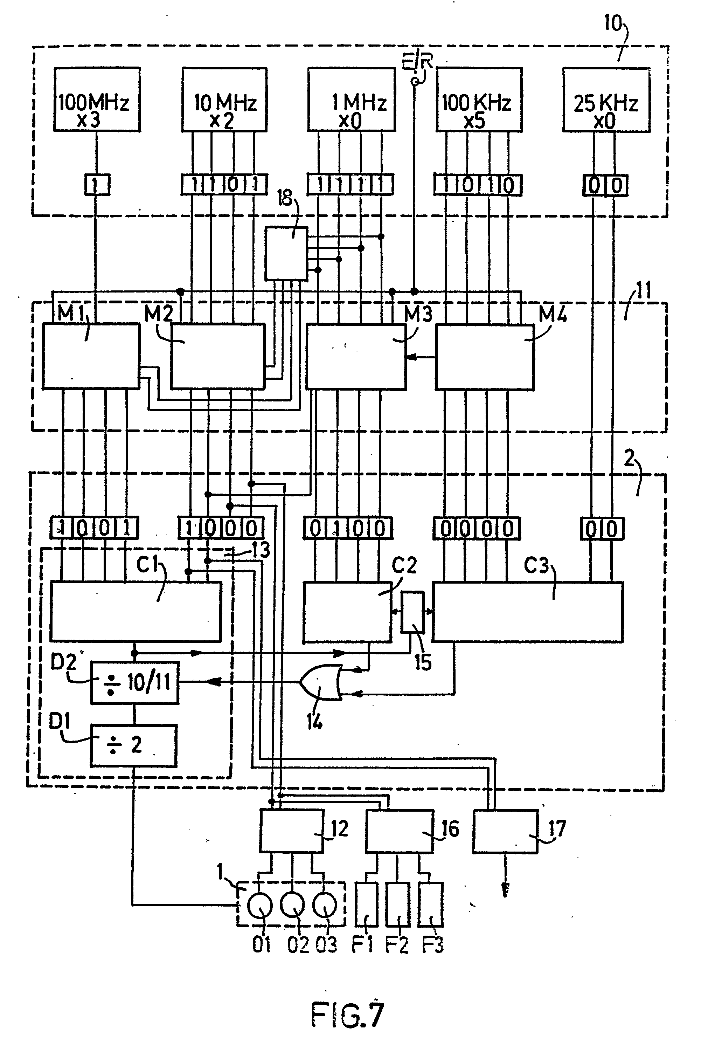

Les figures 6 et 7 montrent l'ensemble des transcodages pour les fréquences de commande affichées de 320 et 320,5 MHz respectivement.

Si maintenant on affiche 329,5 MHz toujours en réception infradyne on a: $F_{Si} = 329,5 - 90,5 = 239$ MHz $= 220 + 19$. Dans ces conditions il convient de propager la retenue puisque la capacité du compteur C2 ne peut excéder 14. Il faut donc programmer ce compteur à 5 MHz pour que des pas 5 à 14 il compte 9 impulsions. La programmation de cette retenue est effectuée par l'intermédiaire du circuit de décodage 18 constitué de portes logiques qui transmettent l'information de retenue aux mémoires M1 et M2 lorsque l'affichage est compris entre 5 et 9 MHz en réception infradyne avec retenue des pas de la décade des centaines de kHz (cas de l'exemple précédent).

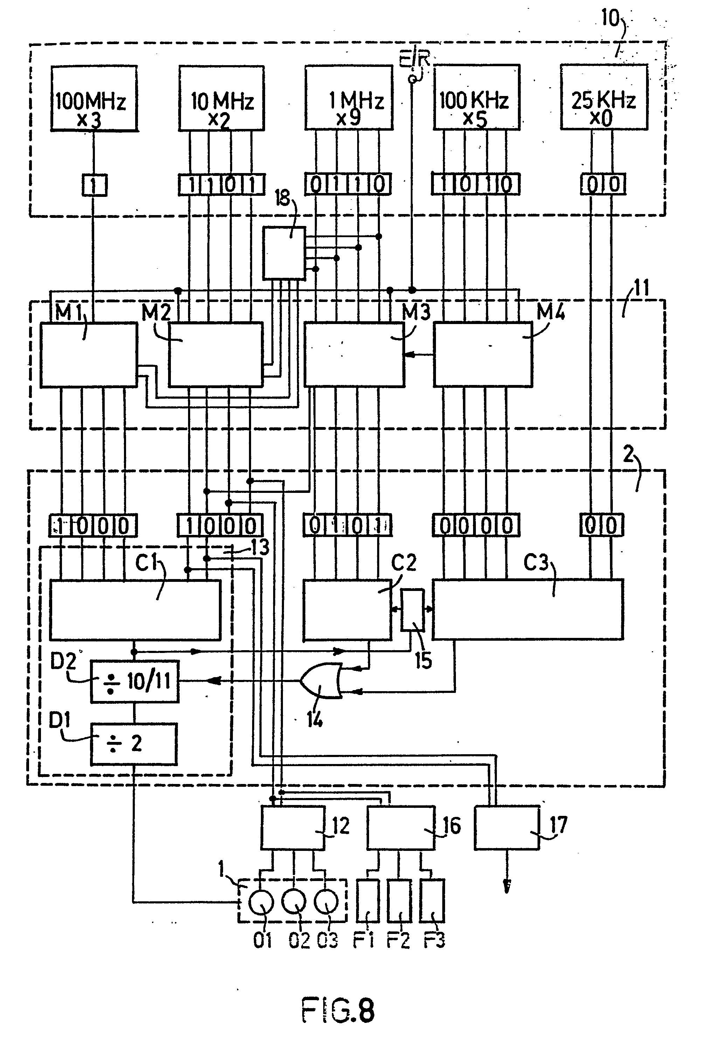

La figure 8 illustre l'ensemble des transcodages pour la fréquence affichée de 329,5 MHz.

## Revendications

1. Procédé de gestion des commandes de fréquence d'un poste émetteur-récepteur avec synthétiseur de fréquence, la boucle de verrouillage de phase dudit synthétiseur comportant entre autres un dispositif oscillant (1) à plusieurs oscillateurs commandables (01, 02, 03) et un dispositif diviseur de fréquence variable (2) qui reçoit sous la forme d'un code numérique l'information de la fréquence de commande dudit synthétiseur à travers un circuit de transcodage (11) constitué par des mémoires (M1, M2, M3, M4), ledit circuit de transcodage recevant sous la forme d'un autre code numérique l'information de la fréquence de commande dudit poste émetteur-récepteur affichée par l'opérateur au moyen d'un dispositif d'affichage de fréquence (10) qui comporte différentes décades, l'affichage sur chacune d'elles pouvant être varié par pas, ledit dispositif diviseur de fréquence variable comportant la chaîne de division proprement dite formée principalement d'un premier compteur programmable (C1) associé à une première et à une seconde mémoire (M1, M2) dudit circuit de transcodage et d'un diviseur par 10 ou par 11 (D2) commandé soit par un second, soit par un troisième compteur programmable (C2, C3), lesdits second et troisième compteurs programmables étant associés respectivement à une troisième et à une quatrième mémoire (M3, M4) du circuit de transcodage, caractérisé en ce que ledit circuit de transcodage constitué par lesdites mémoires reçoit les informations du mode de fonctionnement émission ou réception (E/R) et les informations codées des valeurs de fréquence de commande dudit poste de manière à déterminer par le calcul selon les valeurs de la fréquence intermédiaire, de la fréquence de référence et du pas d'incrémentation en fréquence, les valeurs de fréquence de commande du synthétiseur, l'inversion du mode de fonctionnement supradyne/infradyne, la sélection des filtres correspondant aux sous-gammes du récepteur, la sélection desdits oscillateurs commandables et l'élaboration des fréquences interdites, l'algorithme régissant ledit calcul étant constitué par la programmation desdites mémoires.

2. Procédé de gestion selon la revendication 1, caractérisé en ce que ledit poste fonctionnant en réception supradyne, il y a lieu de prévoir une retenue à partir du pas 5 de la gamme d'affichage des centaines de kHz et de la propager au niveau de la programmation dudit second compteur programmable.

3. Procédé de gestion selon la revendication 1, caractérisé en ce que ledit poste fonctionnant en réception infradyne, la retenue qui s'impose à partir des pas 5 à 9 de la gamme d'affichage des unités de MHz est transmise auxdites première et seconde mémoires par l'intermédiaire d'un premier circuit de décodage (18).

4. Procédé de gestion selon la revendication 1, caractérisé en ce que la programmation de la fonction sélection desdits filtres et de la fonction sélection desdits oscillateurs est effectuée à partir des digits de ladite seconde mémoire non utilisés pour la programmation dudit premier compteur, un deuxième circuit de décodage (16) transformant le code programmé en un autre code directement utilisable pour assurer la commutation desdits filtres et un troisième circuit de décodage (12) remplissant un rôle identique au premier pour la commutation desdits oscillateurs.

5. Procédé de gestion selon la revendication 1, caractérisé en ce que la programmation desdites informations de fréquences interdites est obtenue en modifiant au moyen d'une information codée provenant de ladite troisième mémoire la valeur du second digit de ladite seconde mémoire correspondant à la programmation dudit premier compteur à partir des deux digits de poids les plus forts, la paire de digits ainsi modifiée étant appliquée à un quatrième circuit de décodage (17) fournissant pour l'affichage desdites fréquences interdites une information logique zéro.

## Patentansprüche

1. Verfahren zum Durchführen der Frequenzsteuerungen eines Senders-Empfängers mit Frequenzsynthesierer, wobei die Phasenverriegelungsschleife dieses Synthesierers u.a. eine Oszillatorschaltung (1) mit mehreren steuerbaren Oszillatoren (01, 02, 03) und einen variablen Frequenzteiler (2) enthält, der die Information der Steuerfrequenz des Synthesierers in Form eines Digitalcodes über einen Codeumsetzer (11) mit Speichern (M1, M2, M3, M4) empfängt, wobei der Codeumsetzer die vom Bediener mit Hilfe einer Frequenzeingabe (10) eingegebene Information der Steuerfrequenz des Senders-Empfängers in Form eines anderen Digitalcodes empfängt, wobei diese Eingabe mehrere Dekaden enthält und an jeder Dekade schrittweise veränderbar ist und der variable Frequenzteiler die sog. Teilerkette enthält, die im wesentlichen aus einem ersten programmierbaren Zähler (C1) in Verbindung mit einem ersten und einem zweiten Speicher (M1, M2) des Codeumsetzers und aus einem von einem zweiten oder von einem dritten programmierbaren Zähler (C2, C3) gesteuerten Zehnteiler oder Elfteiler (D2) besteht, wobei die zweiten und dritten programmierbaren Zähler einem dritten und einem vierten Speicher (M3, M4) des Codeumsetzers zugeordnet sind, dadurch gekennzeichnet, dass der aus diesen Speichern aufgebaute Codeumsetzer die Informationen über die Sende- oder Empfangsbetriebsart (E/R) und die codierten Informationen über die Frequenzwerte zum Steuern des Senders-Empfängers dadurch empfängt, dass diese Informationen durch Berechnung aus den Werten der Zwischenfrequenz der Referenzfrequenz und des Frequenzerhöhungsschrittes, der Steuerfrequenzwerte des Synthesierers, der Umkehrung der Betriebsart supradyne/infradyne (Überlagerung/Unterlagerung), der Wahl der Filter entsprechend der Unterbereiche des Empfängers, der Wahl der steuerbaren Oszillatoren und der Verarbeitung der ungewünschten Frequenzen bestimmt werden, wobei der die Berechnung beherrschende Algorithmus durch die Programmierung der Speicher gebildet wird.

2. Verfahren nach Anspruch 1, dadurch gekennzeichnet, dass wenn der Sender-Empfänger im Supradyne-Empfangsbetrieb arbeitet, vom 5. Schritt des Eingabebereichs der kHz-Hunderter an ein negativer Übertrag zu berücksichtigen ist und dieser auf dem Niveau der Programmierung des zweiten programmierbaren Zählers weiterzuführen ist.

3. Verfahren nach Anspruch 1, dadurch gekennzeichnet, dass, wenn der Sender-Empfänger im Infradyne-Empfangsbereich arbeitet, der negative Übertrag, der von den Schritten 5 bis 9 des Eingabebereichs der MHz-Einsen an auftritt, über einen ersten Decoder (18) auf die ersten und zweiten Speicher übertragen wird.

4. Verfahren nach Anspruch 1, dadurch gekennzeichnet, dass die Programmierung der Wählfunktion der Filter und der Wählfunktion der Oszillatoren ausgehend von den Ziffern des zweiten Speichers erfolgt, der nicht zum Programmieren des ersten Zählers benutzt wird, wobei ein zweiter Decoder (16) den programmierten Code in einen anderen, zur Gewährleistung des Schaltvorganges der Filter direkt verwendbaren Code umsetzt und ein dritter Decoder (12) die der ersten entsprechende Rolle zum Schalten der Oszillatoren erfüllt.

5. Verfahren nach Anspruch 1, dadurch gekennzeichnet, dass die Programmierung der Information unerwünschter Frequenzen durch die Änderung des Wertes der zweiten Ziffer des zweiten Speichers entsprechend der Programmierung des ersten Zählers auf Basis der zwei Ziffern mit dem grössten Gewicht mit Hilfe einer codierten Information aus dem dritten Speicher erhalten wird, wobei das auf diese Weise geänderte Ziffernpaar einem vierten Decoder (17) zugeführt wird, der für die Eingabe der unerwünschten Frequenzen eine Information logisch Null liefert.

## Claims

1. A method of managing the frequency control information of a transmitter-receiver station with a frequency synthesizer, the phaselocked loop of said synthesizer comprising inter alia an oscillator arrangement (1) comprising several controllable oscillators (01, 02, 03) and a variable frequency divider (2) receiving in the form of a digital code the information of the control frequency of said synthesizer through a code conversion circuit (11) constituted by memories (M1, M2, M3, M4), said code conversion circuit receiving in the form of another digital code the information on the control frequency of said transmitter-receiver station displayed by the operator by means of a frequency display device (10) which comprises several digital scalers, it being possible to vary the display on each of these scalers step-wise, said variable frequency divider arrangement comprising the actual divider chain which is formed fundamentally by a first programmable counter (C1) associated with a first and with a second memory (M1, M2) of said code conversion circuit and a divide-by-10 divider or a divide-by-11 divider (D2) which is either controlled by a second or a third programmable counter (C2, C3), said second and third programmable counter being associated with a third and a fourth memory (M3, M4), respectively, of the code conversion circuit, characterized in that said code conversion circuit constituted by said memories receives the information on the mode of operation, the transmitter or receiving mode (E/R) and the encoded data of the values of the control frequency of said station such that by means of calculation on the basis of the values of the intermediate frequency, the reference frequency and the frequency incrementation step it is possible to determine the values of the control frequency of the synthesizer, the switch from the supradyne mode of operation to the infradyne mode of operation, selection of the filters corresponding to the sub-ranges of the receiver, the selection of said controllable oscillators and the handling of the information of prohibited frequencies, the algorithm governing said calculation being constituted by the programming of said memories.

2. A management method as claimed in claim 1, characterized in that when said station operates in the supradyne receiving mode, a carry must be provided from step 5 onwards of the display range of hundreds of kHZ and to convey it to the programming section of said second programmable counter.

3. A management method as claimed in claim 1, characterized in that when said station operates in the infradyne receiving mode, the carry required from steps 5 to 9 of the display range of the units of MHz is transmitted to said first and second memories via a first decoding circuit (18).

4. A management method as claimed in claim 1, characterized in that programming the selection function of said filters and the selection function of said oscillators is effected on the basis of the digits of said second memory not utilized for programming said first counter, in that a second decoding circuit (16) is provided for converting the programmed code into another code which can be directly utilized for ensuring the switching of said filters and in that a third decoding circuit (12), which performs the same part as the first circuit, is provided for switching said oscillators.

5. A management method as claimed in claim 1, characterized in that programming the said information of prohibited frequency is obtained by modifying by means of a coded information from said third memory the value of the second digit of said second memory corresponding to the programming of said first counter on the basis of the two most significant digits, the pair of digits thus modified being applied to a fourth decoding circuit (17) supplying a logic information zero for displaying said prohibited frequencies.

FIG.1

FIG.2

0 075 376

FIG.3

FIG.4

FIG.5

FIG.6

FIG.7

FIG.8